# EUROPEAN PATENT APPLICATION

(11) **EP 1 806 814 A2**
(43) Date of publication of application: **11.07.2007**
(21) Application number: 06026017.1
(22) Date of filing: 15.12.2006
(51) Int. Cl.: H02B 1/052

(54) **DIN rail mountable housing**

(30) Priority: 05.01.2006 DE 202006000125 U
(71) Applicant: Bernic A/S, 3480 Fredensborg (DK)
(72) Inventor: Friderichsen, Lars, 3480 Fredensborg (DK)
(74) Representative: Gregersen, Niels Henrik

(57) **Abstract**

A DIN rail mountable cabinet (2, 6, 10) comprising a base member adapted to cooperate with a DIN rail, a staircase shaped main housing for receiving equipment having a certain width and a certain height and having a highest central cabinet part (4, 8) adapted to protrude through a common elongate opening of a cover, where said cabinet at least at one side of said central cabinet part and at least in one level is provided with connecting means (12, 13, 14, 15) for at least one cabinet extension section (16, 18, 20) and for a number of alternative covers. By simple provisions and in a new manner it hereby becomes possible to obtain a substantial increase of the effective internal volume of such DIN rail mountable cabinets.

## Description

### Field of the Invention

The present invention relates to DIN rail mountable cabinets for electric and/or electronic devices and of the type disclosed in the introductory part of claim 1

### Background of the Invention

In practice it is in many situations very difficult to have enough effective internal volume in such DIN rail mounted cabinets because of the nature of such cabinets and the fact that such minor electric switchboard systems normally are working with certain maximum width of each single cabinet component determined by the possible numbers of electric and/or electronic devices being mounted in a DIN rail of a given length.

EP-A2-1 296 425 discloses an expandable housing which can be DIN rail mounted or surface mounted, comprising a base adapted to cooperate with a DIN rail, a main housing for receiving equipment, and an initially separate extension section that is adapted to engage the main housing to increase the effective internal volume of the enclosure for receiving equipment.

### Purpose of the Invention

On this background it is the purpose of the present invention to provide a new and improved DIN rail mountable cabinet of the introductory mentioned type and by means of which it by means of simple provisions may be possible in a new manner to obtain an increase of the effective internal volume of such DIN rail mountable cabinets.

### Description of the Invention

According to the invention there is provided a DIN rail mountable cabinet of the introductory mentioned type characterized in that said cabinet at least at one side of said central cabinet part and at least in one level is provided with connecting means for at least one cabinet extension section and for a number of alternative covers. By simple provisions and in a new manner it hereby becomes possible to obtain a substantial increase of the effective internal volume of such DIN rail mountable cabinets.

The cabinet according to the invention may furthermore be such provided, that said cabinet at two sides, namely at the top side and the bottom side and at more levels being is provided with said connecting means for said cabinet extension sections or said alternative covers.

Appropriately the cabinet according to invention may be such provided, that said cabinet have a larger width for containing equipment of larger width and that said cabinet at two sides, namely at the top side and the bottom side and at more levels being provided with said connection means for more neighbouring cabinet extension sections and/or said alternative covers.

The cabinet according to the invention may furthermore be such provided, that an upper level part of said cabinet extension section has plane side walls and an arched front wall, and that said arched front wall is provided with a number of also arched cooling slots.

Alternatively the cabinet according to the invention may be such provided, that an upper level part of said cabinet extension section has plane side and front walls, and that said plane front wall of said cabinet extension section is provided with a number of cooling slots.

The cabinet according to the invention preferably may be such provided, that is the width of said main housing and said cabinet extension sections is defined by a number of width modules each having a basic width of 175 mm.

### Description of the Drawing

The invention is explained in more detail with reference to the accompanying drawing, in which:
- Fig. 1: is a perspective view of an embodiment for a DIN rail mountable staircase shaped cabinet according to the invention,
- Fig. 2: is a perspective view of another embodiment for a DIN rail mountable stair-case shaped cabinet according to the invention,
- Fig. 3: is a perspective view of a further embodiment for a DIN rail montable stair-case shaped cabinet according to the invention,
- Fig. 4: is a perspective view of an embodiment for a cabinet extension section for two levels of a cabinet according to the invention,
- Fig. 5: is a perspective view of another embodiment for a cabinet extension section for two levels of a cabinet according to the invention,
- Fig. 6: is a perspective vies of a further embodiment for a cabinet extension section for two levels of a cabinet according to the invention,
- Fig. 7: is a perspective view of a still further embodiment for a cabinet extension section for two levels of a cabinet according to the invention,
- Fig. 8: is a perspective view of an embodiment for a cabinet extension section for one level of a cabinet according to the invention,
- Fig. 9: is a perspective view of another embodiment for a cabinet extension section for one level of a cabinet according to the invention, and
- Fig. 10: is a perspective view of a further embodiment for a cabinet extension section for one level of a cabinet according to the invention.

### Detailed Description of the Invention

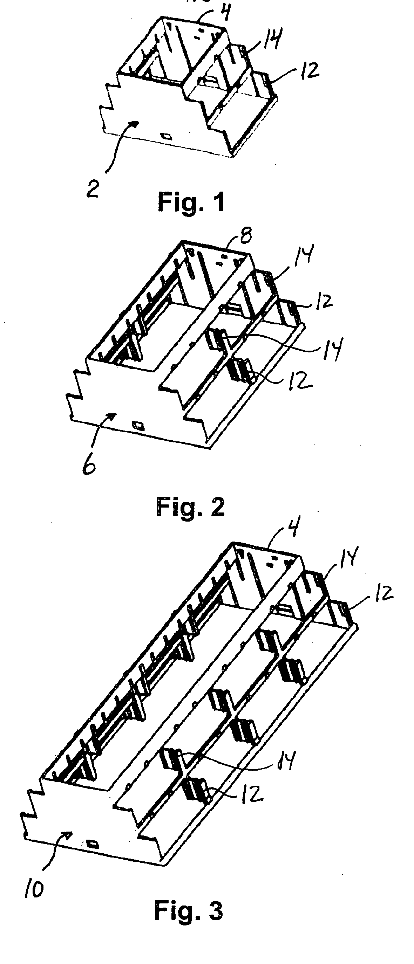

The staircase shaped cabinet 2 shown in Fig. 1 have three levels with a central highest level 4 adapted to protrude through a common cover of a minor electric switchboard system. The width of the cabinet 2 is 525 mm corresponding to three times of a basic width module of 175 mm.

The staircase shaped cabinet 6 shown in Fig. 2 have also three levels with a central, longitudinal highest level 8. The width of the cabinet 6 is 1050 mm corresponding to six times of a basic width module of 175 mm, while the similar staircase shaped cabinet 10 shown in Fig. 3 has a width of 2100 mm corresponding to twelve times the basic module width of 175 mm.

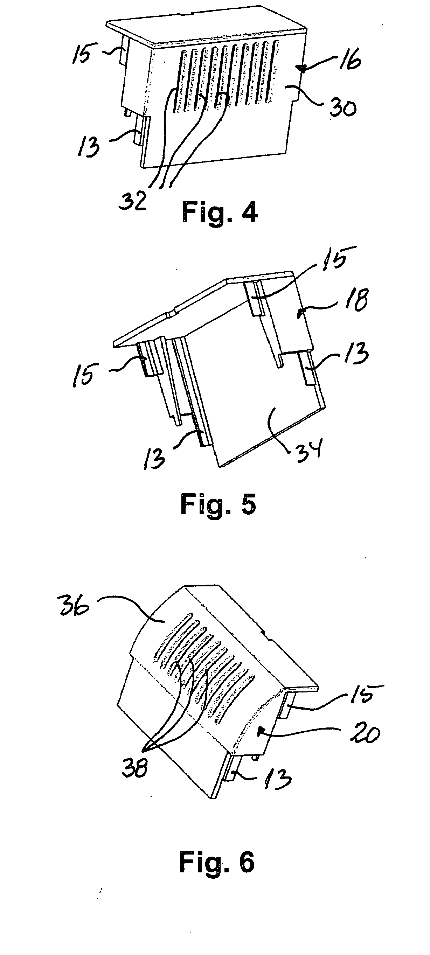

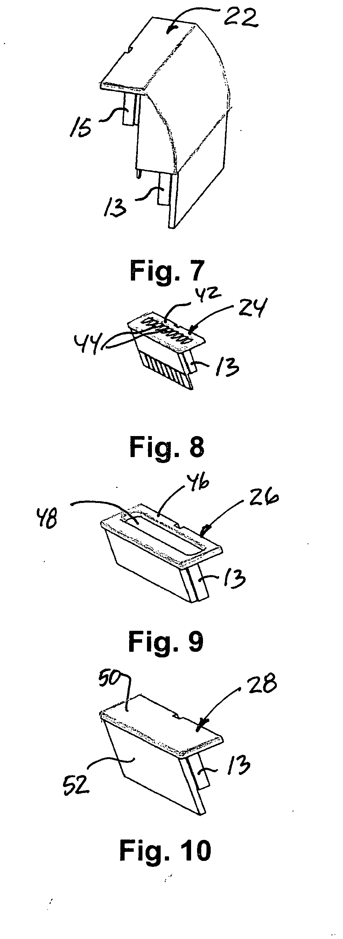

The cabinets 2, 6, 10 are all in the two lower levels provided with connecting means 12, 14 having a mutual distance similar to the width of the cabinet 2 allowing cabinet extensions sections 16, 18, 20, 22 for two levels shown in Figs. 4-7, and cabinet extension sections 24, 26, 28 for one level shown in Figs. 8-10 to be attached the opposite sides of said two lower levels of the staircase cabinets 2, 6, 10 by means of connecting means 13, 15 being cooperating with the connecting means 12, 14 of the cabinets 2, 6, 10.

The cabinet extension section 16 of Fig. 4 is in a plane front side panel 30 provided with cooling slots 32, while the cabinet extension section 18 of Fig. 5 has a closed plane front side 34.

The cabinet extension section 20 of Fig. 6 is in an arched front panel 36 provided with also arched cooling slots 38, while the cabinet extension section 22 of Fig. 7 has a closed arched front side panel 40.

The cabinet extension section 24 of Fig. 8 is in a top side panel 42 provided with a number of openings 44 to not shown electric terminals, while the cabinet extension section 26 of Fig. 9 is in a top side panel 46 provided with an elongate common opening 48 to not shown electric terminals. The cabinet extension section 28 of Fig. 10 is provided with a closed top side panel 50 and also closed front side panel 52.

Finally is should be mentioned that the main aspect of the invention - to be able to arrange suitable cabinet extensions at both sides of the staircase shaped main cabinet housing - may be obtained by combination in many other manners of the shown and described cabinet extension sections according to the invention, and that the staircase shaped cabinet according to the invention even may be adapted to be wall-mounted.

## Claims

1. A DIN rail mountable cabinet (2, 6, 10) comprising a base member adapted to cooperate with a DIN rail, a staircase shaped main housing for receiving equipment having a certain width and a certain height and having a highest central cabinet part (4, 8) adapted to protrude through a common elongate opening of a cover, **characterized in, that** said cabinet at least at one side of said central cabinet part and at least in one level is provided with connecting means (12, 13, 14, 15) for at least one cabinet extension section (16, 18, 20, 22, 24, 26, 28) and for a number of alternative covers.

2. A cabinet (2, 6, 10) according to claim 1, **characterized in, that** said cabinet at two sides, namely at the top side and the bottom side and at more levels being is provided with said connecting means (12, 13, 14, 15) for said cabinet extension sections (16, 18, 20, 22, 24, 26, 28) or said alternative covers.

3. A cabinet (2, 6, 10) according to claim 1, **characterized in, that** said cabinet have a larger width for containing equipment of larger width and that said cabinet at two sides, namely at the top side and the bottom side and at more levels being provided with said connection means (12, 13, 14, 15) for more neighbouring cabinet extension sections (16, 18, 20, 22, 24, 26, 28) and/or said alternative covers.

4. A cabinet (2, 6, 10) according to claim 1, **characterized in, that** an upper level part of said cabinet extension section (20, 22) has plane side walls and an arched front wall (36).

5. A cabinet (2, 6, 10) according to claim 4, **characterized in, that** said arched front wall (36) is provided with a number of also arched cooling slots (38).

6. A cabinet (2, 6, 10) according to claim 1, **characterized in, that** an upper level part of said cabinet extension (16, 18) section has plane side and front walls (30, 34).

7. A cabinet (2, 6, 10) according to claim 6, **characterized in, that** said plane front wall (30) of said cabinet extension section (16) is provided with a number of cooling slots (32).

8. A cabinet (2, 6, 10) according to claim 1, **characterized in, that** the width of said main housing and said cabinet extension sections is defined by a number of width modules each having a basic width of 175 mm.
